(19) **Europäisches Patentamt**

**European Patent Office**

**Office européen des brevets**

(11) **EP 0 860 706 B1**

(12) **EUROPÄISCHE PATENTSCHRIFT**

(45) Veröffentlichungstag und Bekanntmachung des Hinweises auf die Patenterteilung:
**06.04.2005 Patentblatt 2005/14**

(51) Int Cl.[7]: **G01R 33/28**

(21) Anmeldenummer: **98200412.9**

(22) Anmeldetag: **10.02.1998**

(54) **MR-Verfahren und MR-Anordnung zur Bestimmung der Position einer Mikrospule**

MR method and apparatus for determining the position of a microcoil

Procédé RM et dispositif pour déterminer la position d'une microbobine

(84) Benannte Vertragsstaaten:
**DE FR GB NL**

(30) Priorität: **20.02.1997 DE 19706703**

(43) Veröffentlichungstag der Anmeldung:
**26.08.1998 Patentblatt 1998/35**

(73) Patentinhaber:
• **Philips Intellectual Property & Standards GmbH**
**20099 Hamburg (DE)**
Benannte Vertragsstaaten:
**DE**
• **Koninklijke Philips Electronics N.V.**
**5621 BA Eindhoven (NL)**
Benannte Vertragsstaaten:
**FR GB NL**

(72) Erfinder:
• **Börnert, Peter, Dr.**
**Röntgenstrasse 24, 22335 Hamburg (DE)**
• **Weiger, Markus**
**Röntgenstrasse 24, 22335 Hamburg (DE)**
• **Aldefeld, Bernd, Dr.**
**Röntgenstrasse 24, 22335 Hamburg (DE)**

(74) Vertreter: **Volmer, Georg, Dipl.-Ing. et al**
**Philips Intellectual Property & Standards GmbH,**
**Postfach 50 04 42**
**52088 Aachen (DE)**

(56) Entgegenhaltungen:
• **DUMOULIN C L ET AL: "REAL-TIME POSITION MONITORING OF INVASIVE DEVICES USING MAGNETIC RESONANCE" MAGNETIC RESONANCE IN MEDICINE, Bd. 29, Nr. 3, 1.März 1993, Seiten 411-415, XP000354656**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein MR-Verfahren zur Bestimmung der Position wenigstens einer Mikrospule, die sich in oder an einem in einem Untersuchungsbereich befindlichen Untersuchungsobjekt befindet, wobei während der Erfassung von Mikrospulen-MR-Signalen mindestens ein veränderbares magnetisches Gradientenfeld auf den Untersuchungsbereich einwirkt, so daß der k-Raum mindestens zweidimensional an Abtastpunkten abgetastet wird.

Als Mikrospulen wird dabei und im folgenden eine Spule bezeichnet, die MR-Signale lediglich aus einem Bereich aufnehmen kann, der klein ist im Vergleich zum gesamten Untersuchungsbereich. Zur Unterscheidung von anderen, beispielsweise mittels einer Empfangsspulen-Anordnung detektierten MR-Signalen zur Bestimmung der Kernmagnetisierungsverteilung im Untersuchungsbereich, werden die von der Mikrospule aufgenommenen MR-Signale als Mikrospulen-MR-Signale bezeichnet. MR steht für magnetische Resonanz. Als k-Raum wird der Ortsfrequenzraum bezeichnet, der durch Veränderung der magnetischen Gradientenfelder an Abtastpunkten abgetastet wird.

Ein MR-Verfahren der eingangs genannten Art ist aus der EP-A 731 362 bekannt. Der k-Raum wird dabei an Abtastpunkten abgetastet, die auf radialen, durch den Nullpunkt des k-Raumes verlaufenden Pfaden liegen. Die Position der Mikrospule wird durch Frequenzanalyse eines Mikrospulen-MR-Signals bestimmt, indem das Maximum des Spektrums eines Mikrospulen-MR-Signals (d.h. der Fouriertransformierten des Mikrospulen-MR-Signals) bestimmt wird. Dieses MR-Verfahren ist jedoch auf die Anwendung bei radialer Abtastung des k-Raumes beschränkt und erfordert außerdem die Bechnung der Fouriertransformierten von Mikrospulen-MR-Signalen.

Der vorliegenden Erfindung liegt die Aufgabe zugrunde, ein MR-Verfahren zur Bestimmung der Position einer Mikrospule anzugeben, welches unabhängig von der Art der Abtastung des k-Raumes anwendbar ist.

Diese Aufgabe wird erfindungsgemäß gelöst durch die kennzeichnenden Merkmale von Anspruch 1.

Der Erfindung liegt dabei der Gedanke zugrunde, die Position der Mikrospule direkt aus den gemessenen Mikrospulen-MR-Signalen zu bestimmen, ohne vorher eine Fouriertransformation oder eine andere Transformation auf das gemessene Mikrospulen-MR-Signal anwenden zu müssen. Für jeden (gemessenen) Abtastwert eines Mikrospulen-MR-Signals kann ein Zusammenhang mit den zugeordneten (bekannten) Abtastpunkten (k-Werten) im k-Raum und den gesuchten Positionswerten der Mikrospule in Form einer Gleichung hergestellt werden. Zugeordnet heißt in diesem Zusammenhang, daß eine Gleichung aufgestellt werden kann für die Abtastpunkte und den Abtastwert, die zum selben Abtastzeitpunkt gehören. Aus mehreren solcher Gleichungen läßt sich ein Gleichungssystem erstellen. Eine Lösung dieses Gleichungssystems wird dann mit unterschiedlichen mathematischen Methoden ermittelt, d.h. es werden die Positionswerte der aktuellen Position der Mikrospule bestimmt.

Eine Weiterbildung des erfindungsgemäßen MR-Verfahrens sieht vor, daß die Phasenwerte von Abtastwerten eines Mikrospulen-MR-Signals ermittelt werden und daß die Position der Mikrospule aus wenigstens zwei Phasenwerten und den k-Raum-Koordinaten der zugeordneten Abtastpunkte bestimmt wird. Für jeden Abtastwert kann ein Phasenwert berechnet werden, der den Wert der sogenannten akkumulierten Phase bildet. Die akkumulierte Phase beschreibt den Winkel der Präzessionsbewegung der in der Nähe der Mikrospule befindlichen Spins unter dem Einfluß des magnetischen Gradientenfeldes. Die oben genannten Gleichungen lassen sich auch in anderer Form schreiben, so daß sie einen Zusammenhang herstellen zwischen einem Phasenwert, den zugeordneten Abtastpunkten im k-Raum und den gesuchten Positionswerten der Mikrospule. Aus mehreren, diese Zusammenhänge beschreibenden Gleichungen läßt sich wiederum ein Gleichungssystem bilden, das mit verschiedenen mathematischen Methoden (näherungsweise) gelöst werden kann zur Bestimmung der Positionswerte der Mikrospule.

In einer Ausgestaltung des erfindungsgemäßen MR-Verfahrens ist vorgesehen, daß die Position der Mikrospule durch Minimierung einer Fehlerfunktion bestimmt wird, wobei die Fehlerfunktion aus Gleichungen gebildet wird, welche jeweils den Zusammenhang zwischen einem Abtastwert eines Mikrospulen-MR-Signals, den k-Raum-Koordinaten der zugeordneten Abtastpunkte und den gesuchten Positionswerten der Mikrospule beschreiben. Da den gemessenen Mikrospulen-MR-Signalen Rauschen überlagert ist, ist es in der Regel nicht möglich, eine exakte Lösung für die Positionswerte der Mikrospule durch Lösung eines aus zwei oder drei Gleichungen bestehenden Gleichungssystems zu finden. Bevorzugt wird deshalb eine Vielzahl von Gleichungen herangezogen, wodurch sich ein überbestimmtes Gleichungssystem ergibt, dessen Lösung durch Minimierung einer Fehlerfunktion bestimmt wird.

Eine davon ausgehende Weiterbildung des erfindungsgemäßen MR-Verfahrens sieht vor, daß die Fehlerfunktion aus Differenzwerten zwischen jeweils einem Abtastwert eines Mikrospulen-MR-Signals und einem aus den k-Raum-Koordinaten der zugeordneten Abtastpunkte und den Positionswerten der Mikrospule gebildeten Signal-Rechenwert gebildet wird und daß zur Minimierung der Fehlerfunktion Werte der Fehlerfunktion für verschiedene Positionswerte ermittelt werden. Die Fehlerfunktion kann dabei beispielsweise aus der Summe einer Vielzahl von zum Quadrat genommenen Differenzwerten bestehen. Ein Minimum der Fehlerfunktion kann mit bekannten Suchalgorithmen gefunden werden, die u.a. Werte der Fehlerfunktion für unterschiedliche Positionswerte ermitteln. Die Positionswerte, für die sich ein Minimum ergibt, sind dann die gesuchten Positionswerte der Mikrospule.

Eine alternative Weiterbildung des erfindungsgemäßen MR-Verfahrens sieht vor, daß die Phasenwerte von Abtastwerten eines Mikrospulen-MR-Signals ermittelt werden, daß die Fehlerfunktion aus Differenzwerten zwischen jeweils einem Phasenwert und einem aus den k-Raum-Koordinaten der zugeordneten Abtastpunkte und den Positionswerten der Mikrospule gebildeten Phasen-Rechenwert gebildet wird und daß zur Minimierung der Fehlerfunktion Werte der Fehlerfunktion für verschiedene Positionswerte ermittelt werden. Der Unterschied zu der vorgenannten Weiterbildung liegt im wesentlichen darin, daß hier zunächst die Phasenwerte von Abtastwerten ermittelt werden und daß daraus Differenzwerte ausgehend von dem weiter oben genannten Zusammenhang zwischen einem Phasenwert, den zugeordneten Abtastpunkten und den Positionswerten gebildet werden, die in die Fehlerfunktion eingehen. Ansonsten gilt hier analog das zur vorgenannten Weiterbildung Gesagte.

In einer Ausgestaltung des erfindungsgemäßen MR-Verfahrens ist vorgesehen, daß bei der Bestimmung der Position der Mikrospule Positionswerte der vorherigen Position der Mikrospule und/oder die Bewegungsrichtung der Mikrospule berücksichtigt werden. Dadurch kann der Rechenaufwand zur Bestimmung der aktuellen Position erheblich vermindert werden. Ist beispielsweise die Bewegungsrichtung der Mikrospule auch nur in etwa bekannt, so genügt es, Werte einer Fehlerfunktion nur für Positionswerte zu berechnen, die in dieser Richtung liegen. Auch die Kenntnis der vorherigen Position der Mikrospule reduziert den Rechenaufwand, da in der Regel die Vorschubgeschwindigkeit der Mikrospule bekannt ist und deshalb die Berechnung von Werten der Fehlerfunktion ebenfalls auf eine bestimmte Umgebung der vorherigen Position der Mikrospule beschränkt werden kann.

Eine weitere Ausgestaltung des erfindungsgemäßen MR-Verfahrens sieht vor, daß die Position der Mikrospule aus wenigstens zwei voneinander unabhängigen Gleichungen bestimmt wird, welche jeweils den Zusammenhang zwischen einem Abtastwert eines Mikrospulen-MR-Signals, den k-Raum-Koordinaten der zugeordneten Abtastpunkte und den gesuchten Positionswerten der Mikrospule beschreiben. Idealerweise genügen zwei bzw. drei Gleichungen, um zwei (im zweidimensionalen Fall) bzw. drei (im dreidimensionalen Fall) Positionswerte der Mikrospule exakt zu bestimmen. Je nach Abtastverfahren, mit dem der k-Raum abgetastet wird, werden geeignete Abtastpunkte zur Aufstellung der genannten Gleichungen und zur Bestimmung der Position der Mikrospule ausgewählt.

Eine bevorzugte Weiterbildung der Erfindung sieht vor, daß mittels einer Empfangsspulen-Anordnung MR-Signale zur Bestimmung der Kernmagnetisierungsverteilung im Untersuchungsbereich und gleichzeitig dazu die Mikrospulen-MR-Signale mittels einer Mikrospule detektiert werden. Dies hat den Vorteil, daß zur Erfassung der Mikrospulen-MR-Signale keine gesonderten MR-Sequenzen erforderlich sind, was zusätzlichen Aufwand und zusätzliche Meßzeit erforderlich machen würde.

Die Erfindung betrifft auch eine MR-Anordnung gemäß Anspruch 9 zur Durchführung des erfindungsgemäßen MR-Verfahrens.

Die Erfindung wird nachfolgend anhand der Zeichnung näher erläutert. Es zeigen:

Fig. 1    eine MR-Anordnung, mit dem die Erfindung ausführbar ist,
Fig. 2    ein Flußablaufdiagramm zur Erläuterung des erfindungsgemäßen MR-Verfahrens,
Fig. 3    die Lage von Abtastpunkten bei spiralförmiger Abtastung des k-Raumes,
Fig. 4    die Lage von Abtastpunkten bei EPI-Abtastung des k-Raumes,
Fig. 5    die Lage von Abtastpunkten bei radialer Abtastung des k-Raumes,
Fig. 6    die Lage von Abtastpunkten bei linearer Abtastung des k-Raumes und
Fig. 7    eine Darstellung des physikalischen Orts-Raumes zur Erläuterung des erfindungsgemäßen MR-Verfahrens.

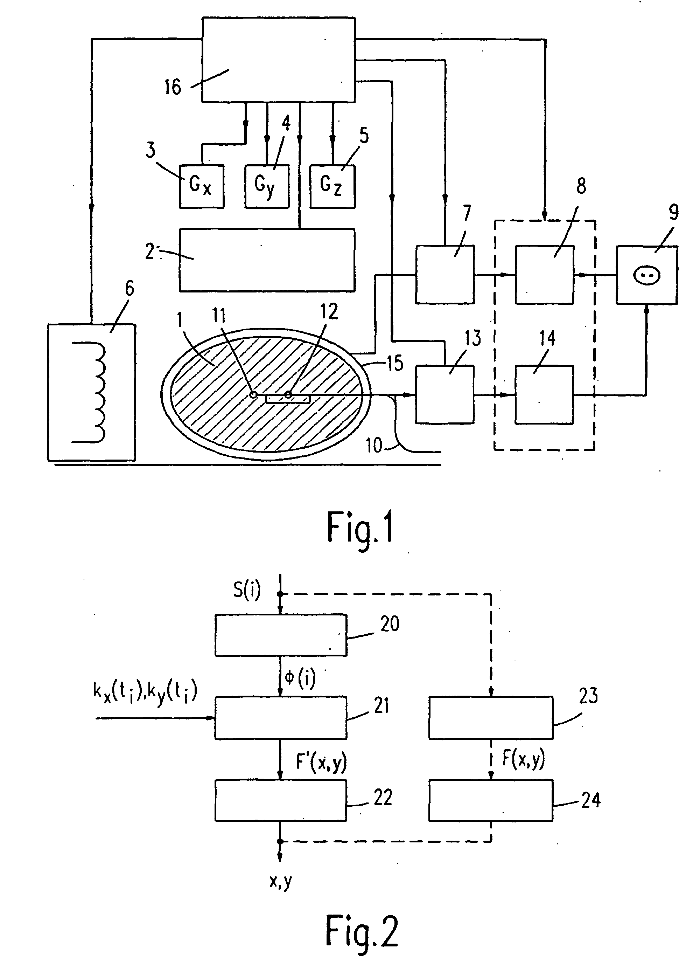

In Fig. 1 ist mit 1 ein Untersuchungsobjekt bezeichnet, das sich in einem Untersuchungsbereich befindet, der einem homogenen stationären Magnetfeld ausgesetzt ist, das von einem Hauptfeldmagneten 2 erzeugt wird. Das stationäre homogene Magnetfeld kann mittels dreier Gradientenanordnungen 3,4 und 5 modifiziert werden, die ein magnetisches Gradientenfeld erzeugen, das ebenfalls in Richtung des homogenen stationären Magnetfeldes verläuft, jedoch in x-, y- oder z-Richtung einen Gradienten aufweist. Weiterhin ist ein Hochfrequenzsender 6 vorgesehen, der im Untersuchungsbereich impulsweise ein hochfrequentes Magnetfeld erzeugen kann.

Die im Untersuchungsobjekt 1 erzeugten MR-Signale werden von einer Empfangsspulen-Anordnung 15 (die aus einer oder mehreren Empfangsspulen bestehen kann) in Verbindung mit einer Empfängeranordnung 7 detektiert (die einen oder mehrere Empfangskanäle aufweisen kann). Aus den digitalisierten MR-Signalen wird nach einer Fourier-Transformation in einer Rekonstruktionseinheit 8 die Kernmagnetisierungsverteilung im Untersuchungsbereich rekonstruiert und im Form eines MR-Bildes auf einer Wiedergabeeinheit 9 wiedergegeben.

In das Untersuchungsobjekt 1 ist ein chirurgisches Instrument eingeführt, beispielsweise ein Katheter 10, an dessen Spitze - und ggf. noch an einer weiteren Stelle - eine Mikrospule 11 bzw. 12 befestigt ist. Die von den Mikrospulen 11, 12 gelieferten Signale werden einer ein- oder mehrkanaligen Empfängeranordnung 13 zugeführt. Die digitalisierten Mikrospulen-MR-Signale werden anschließend einer Auswerteeinheit 14 zugeführt, die die Position der Mikrospule(n) 11, 12 ermittelt und in das auf der Wiedergabeeinheit 9 dargestellte MR-Bild einblendet. Wie gestrichelt angedeutet ist, können die Komponenten 8 und 14 mittels eines geeignet programmierten Rechners realisiert werden. Die Komponenten 2 bis 15 werden durch eine programmierbare Steuereinheit 16 gesteuert.

Anhand des in Fig. 2 dargestellten Flußablaufdiagramms soll das erfindungsgemäße MR-Verfahren näher erläutert werden. Die Abmessungen einer Mikrospule liegen typischerweise im Bereich der Größe der Bildpunkte eines MR-Bildes oder darunter. Die von ihr empfangenen Mikrospulen-MR-Signale stammen daher aus einem kleinen Bereich in der Nähe der Mikrospule, der als punktförmig angesehen werden kann. Unter den Voraussetzungen, daß sich die Mikrospule in der Bildgebungsschicht befindet und daß die z-Achse eines im folgenden zugrundegelegten kartesischen Koordinatensystems senkrecht zur Bildebene orientiert ist, läßt sich ein Abtastwert eines Mikrospulen-MR-Signals aus einem punktförmigen Bereich mathematisch schreiben als

$$S(t_i) = A \exp [-j (k_x(t_i) x + k_y(t_i) y + \Phi_0)], \qquad (1)$$

wobei

$S$            ein gemessenes Mikrospulen-MR-Signal,
$t_i$           der i-te Abtastzeitpunkt,
$A$           eine system- (und orts-)abhängige Konstante,
$k_x(t_i), k_y(t_i)$     die k-Werte in x bzw. y-Richtung (Abtastpunkte im k-Raum),
$x, y$         die zu bestimmende x- bzw. y-Position der Mikrospule und
$\Phi_0$          die Anfangsphase des Mikrospulen-MR-Signals

sind. Die Abtastpunkte $k_x(t_i)$ und $k_y(t_i)$ werden bei der Erzeugung der MR-Sequenz definiert und können deshalb als bekannt angesehen werden. Die Lage der Abtastpunkte $k_x(t_i)$, $k_y(t_i)$ im Ortsfrequenzraum ist durch den zeitlichen Verlauf des zugehörigen Gradientenmagnetfeldes bestimmt derart, daß ein Abtastpunkt dem zeitlichen Integral über den zugehörigen Gradienten entspricht. Während der Erfassung von MR-Signalen werden die magnetischen Gradientenfelder in ihrer Feldstärke und Zeitdauer verändert, wodurch der k-Raum an unterschiedlichen Abtastpunkten $k_x(t_i)$, $k_y(t_i)$ abgetastet wird. Während ein oder mehrere Gradienten (beispielsweise ein Lesegradient) anliegt, werden nacheinander die Abtastwerte $S(t_i)$ erfaßt, die sich ausgehend von obiger Gleichung (1) auch vereinfacht schreiben lassen in der Form

$$S(t_i) = A \exp [-j \Phi(t_i)] , \qquad (2)$$

wobei

$$\Phi(t_i) = k_x(t_i) x + k_y(t_i) y + \Phi_0 \qquad (3)$$

die sogenannte akkumulierte Phase ist.

Im Block 20 wird zunächst aus den Abtastwerten $S(t_i)$ die akkumulierte Phase $\Phi(t_i)$ bestimmt. Die Division des Imaginärteils durch den Realteil des Abtastwertes gemäß Gleichung (2) ergibt zunächst den Tangens der akkumulierten Phase:

$$\tan \Phi(t_i) = - \operatorname{Im}\{S(t_i)\} / \operatorname{Re}\{S(t_i)\}. \qquad (4)$$

Die akkumulierte Phase $\Phi(t_i)$ selbst kann durch Anwendung der Arkustangensfunktion nur modulo $2\pi n$ mit unbekanntem ganzzahligen n bestimmt werden, d.h. es ergibt sich zunächst nur eine Menge von möglichen Werten $\Phi'(t_i)$:

$$\Phi'(t_i) = \Phi(t_i) + 2 \pi n \qquad (5)$$

Für den ersten Wert, also $\Phi'(t_1)$, wird willkürlich n = 0 festgelegt. Weitere Werte werden ausgehend von $\Phi'(t_1)$ schrittweise ermittelt. Von den möglichen Werten für $\Phi'(t_2)$ wird derjenige Wert ausgewählt, der am dichtesten bei $\Phi'(t_1)$ liegt. Daß diese Wahl richtig ist, ergibt sich aus dem Abtast-Theorem, nach welchem der Phasenwinkel zwischen zwei Zeitpunkten der Abtastung höchstens $\pi$ betragen darf. Dieses Verfahren wird fortgesetzt, bis für alle Abtastwerte $S(t_i)$ alle Werte $\Phi(t_i)$ eindeutig ermittelt sind. Statt für $\Phi'(t_2)$ den Wert zu wählen, der am dichtesten bei $\Phi'(t_1)$ liegt, könnte $\Phi'(t_2)$ auch durch eine lokale Korrelation, eine lokale Anpassung oder eine lokale Statistik bestimmt werden.

Ausgehend von Gleichung (3) stellen die Gleichungen für alle Abtastzeitpunkte $t_i = t_1 \ldots t_m$ ein System von m Gleichungen mit den Unbekannten x und y dar:

$$\Phi(t_1) = k_x(t_1)\ x\ +\ k_y(t_1)\ y\ +\ \Phi_0$$
$$\ldots \tag{6}$$
$$\Phi(t_m) = k_x(t_m)\ x\ +\ k_y(t_m)\ y\ +\ \Phi_0 .$$

Die Lösung dieses im allgemeinen überbestimmten Gleichungssystems ergibt die gesuchten Werte x und y. Die Anfangsphase $\Phi_0$ ergibt sich z.B. für $k_x = k_y = 0$. Ausgehend von Gleichungssystem (6) wird in Block 21 eine Fehlerfunktion F' aufgestellt, beispielsweise in der Form

$$F' = \sum_i ([k_x(t_i)\ x\ +\ k_y(t_i)\ y\ +\ \Phi_0)]\ -\ \Phi(t_i))^2 =$$
$$= \sum_i (R'(t_i)\ -\ \Phi(t_i))^2 = \sum_i (D'(t_i))^2 . \tag{7}$$

Diese Fehlerfunktion (die Summe der Fehlerquadrate) enthält Differenzwerte $D'(t_i)$, die sich jeweils aus einer der Gleichungen des Gleichungssystems (6) als Differenz zwischen einem gemessenen Phasenwert $\Phi(t_i)$ und einem Phasen-Rechenwert $R'(t_i) = k_x(t_i)\ x + k_y(t_i)\ y + \Phi_0$ ergeben.

In Block 22 wird die Fehlerfunktion F' mit herkömmlichen mathematischen Methoden minimiert, beispielsweise indem Werte der Fehlerfunktion F' für verschiedene Werte von x, y berechnet werden. Die Werte x, y, für die sich ein Minimum der Fehlerfunktion F' ergibt, sind die gesuchten Positionswerte x, y der Mikrospule.

Bei dem erfindungsgemäßen Verfahren ist keine Fourier-Transformation des Mikrospulen-MR-Signals zur Bestimmung der Position der Mikrospule erforderlich. Ein weiterer Vorteil besteht darin, daß zur Erfassung der Mikrospulen-MR-Signale keine separaten MR-Sequenzen erforderlich sind, sondern daß die Mikrospulen MR-Signale parallel zu den von der Empfangsspulen-Anordnung empfangenen MR-Signalen empfangen werden können.

Eine alternative Lösungsmöglichkeit ist in Fig. 2 gestrichelt eingezeichnet. Ausgehend von den Abtastwerten $S(t_i)$ wird ein Gleichungssystem (8) aufgestellt der folgenden Form:

$$S(t_1) = A\ \exp[-j\ (k_x(t_1)\ x\ +\ k_y(t_1)\ y\ +\ \Phi_0)]$$
$$\ldots \tag{8}$$
$$S(t_m) = A\ \exp[-j\ (k_x(t_m)\ x\ +\ k_y(t_m)\ y\ +\ \Phi_0)]$$

In Block 23 wird daraus eine Fehlerfunktion F gebildet

$$F = \sum_i (A\ \exp[-j\ (k_x(t_i)\ x\ +\ k_y(t_i)\ y\ +\ \Phi_0)]\ -\ S(t_i))^2 =$$
$$= \sum_i (R(t_i)\ -\ S(t_i))^2 = \sum_i (D(t_i))^2 , \tag{9}$$

die als Summe von quadrierten Differenzwerten gebildet ist, wobei ein Differenzwert die Differenz zwischen einem Signalrechenwert $R(t_i) = A\ \exp[-j\ (k_x(t_i)\ x + k_y(t_i)\ y + \Phi_0)]$ und einem Abtastwert $S(t_i)$ enthält. Die Lösung dieser Fehlerfunktion F wird analog zu dem oben beschriebenen Verfahren in Block 24 durch Minimierung bestimmt, woraus sich die gesuchten Positionswerte x, y ergeben.

Die Lösung der Fehlerfunktion F bzw F' kann auch mit anderen bekannten mathematischen Mitteln gefunden werden, beispielsweise durch Anwendung eines Simplex-Algorithmus. Aus dem Gleichungssystem (6) bzw. (8) muß auch nicht notwendigerweise eine Fehlerfunktion gebildet werden. Eine Lösung des Gleichungssystems könne beispielsweise auch durch eine Singulärwert-Zerlegung oder durch andere mathematische Verfahren gefunden werden.

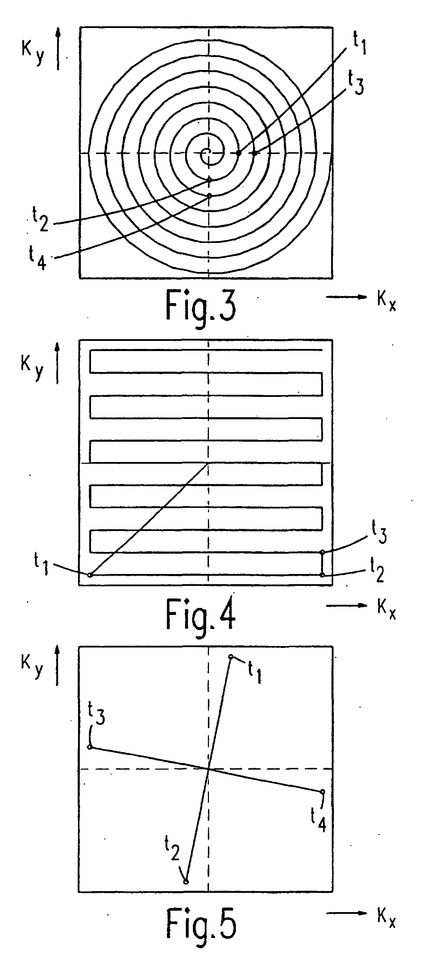

Da die gemessenen Abtastwerte $S(t_i)$ einen verhältnismäßig großen Rauschbeitrag enthalten, wird die Fehlerfunktion F bzw. F' als Summe einer Vielzahl quadrierter Differenzwerte $D(t_i)$ bzw. $D'(t_i)$ gebildet, um den Einfluß des Rauschens weitestgehend zu unterdrücken und eine möglichst genaue Lösung für x und y zu erhalten. Beim erfindungsgemäßen Verfahren läßt sich jedoch auch eine Lösung mit einer geringen Anzahl von Gleichungen (1) bzw. (3) für die Positionswerte x und y bestimmen. Dies soll anhand der folgenden Figuren 3 bis 5 durch unterschiedliche Abtastungen des k-Raumes verdeutlicht werden. Bei den dabei gezeigten Abtastverfahren erfolgt die Abtastung kontinuierlich, d.h. es ergeben sich keine Sprünge in der Phase, so daß die Phase jedes Abtastwertes eindeutig bestimmt werden kann.

Beim Spirialverfahren wird der k-Raum auf spiralförmigen Pfaden durchlaufen (siehe Fig. 3), d. h. die Abtastpunkte $k_x(t_i)$, $k_y(t_i)$ liegen auf spiralförmigen Pfaden. Um den gesamten k-Raum abzudecken, werden im allgemeinen mehrere Subspiralen verwendet. Eine solche Subspirale ist in Fig. 3 gezeigt. Aus der Spiralform des Abtastpfades ergibt sich, daß $k_x$ und $k_y$ zu verschiedenen Zeitpunkten Nullstellen haben. Für die Meßpunkte $t_1$ und $t_3$ gilt:

$$k_y(t_1)=k_y(t_3)=0 \qquad \text{und} \qquad \Phi(t_3) - \Phi(t_1) = [k_x(t_3) - k_x(t_1)] \, x. \qquad (10)$$

Analog gilt an den Meßpunkten $t_2$ und $t_4$:

$$k_x(t_2)=k_x(t_4)=0 \qquad \text{und} \qquad \Phi(t_4) - \Phi(t_2) = [k_y(t_4) - k_y(t_2)] \, y. \qquad (11)$$

Aus Gleichung (10) ergibt sich für die x-Position der Mikrospule:

$$x = [\Phi(t_3) - \Phi(t_1)] / [k_x(t_3) - k_x(t_1)] \qquad (12)$$

und aus Gleichung (11) ergibt sich für die y-Position der Mikrospule

$$y = [\Phi(t_4) - \Phi(t_2)] / [k_y(t_4) - k_y(t_2)]. \qquad (13)$$

Falls die Meßpunkte $t_1$ bis $t_4$ nicht exakt Abtastpunkten $k_x(t_i)$, $k_y(t_i)$ entsprechen, können die Phasenwerte $\Phi(t_1)$ bis $\Phi(t_4)$ leicht durch Interpolation aus den Phasenwerten $\Phi(t_i)$ benachbarter Abtastwerte $S(t_i)$ bestimmt werden.

Beim EPI-Verfahren (EPI = echo planar imaging, Echoplanarverfahren) wird der k-Raum auf parallelen Linien durchlaufen (siehe Fig. 4). Zur Positionsbestimmung werden die Phasenwerte an drei Eckpunkten des k-Raumpfades herangezogen (Abtastzeitpunkte $t_1$, $t_2$, $t_3$). An den Punkten $t_1$ und $t_2$ ist der $k_y$-Wert identisch ($k_y(t_1)=k_y(t_2)$). Mit Hilfe der Gleichung (3) folgt daraus für die x-Position der Mikrospule

$$x = [\Phi(t_2) - \Phi(t_1)] / [k_x(t_2) - k_x(t_1)]. \qquad (14)$$

In analoger Weise gilt für die Meßpunkte $t_2$ und $t_3$ $k_x(t_2)=k_x(t_3)$ und für die y-Position der Mikrospule:

$$y = [\Phi(t_3) - \Phi(t_2)] / [k_y(t_3) - k_y(t_2)]. \qquad (15)$$

Beim Radial-Verfahren wird der k-Raum auf radialen Linien durchlaufen (siehe Fig. 5; dort sind nur zwei radiale Linien gezeigt). Zur Positionsbestimmung werden die Phasenwerte an vier Abtastpunkten herangezogen. Ausgehend von Gleichung (3) wird die Differenz zwischen den Phasenwerten an den Meßpunkten $t_1$ und $t_2$ berechnet:

$$\Phi(t_2) - \Phi(t_1) = [k_x(t_2) - k_x(t_1)] \, x + [k_y(t_2) - k_y(t_1)] \, y. \qquad (16)$$

Analog ergibt sich als Differenz der Phasenwerte an den Meßpunkten $t_3$ und $t_4$:

$$\Phi(t_4) - \Phi(t_3) = [k_x(t_4) - k_x(t_3)] \, x + [k_y(t_4) - k_y(t_3)] \, y. \qquad (17)$$

Die Gleichungen (16) und (17) stellen zusammen ein System von zwei Gleichungen mit zwei Unbekannten dar. Dieses ist eindeutig lösbar, wenn die beiden k-Raumlinien nicht parallel sind. Die Lösung stellt die gesuchte Mikrospulenposition x, y dar.

Das in Zusammenhang mit den Fig. 3 bis 5 beschriebene Verfahren könnte auch dahingehend variiert werden, daß Lösungen für die Werte x, y mehrfach an unterschiedlichen Abtastpunkten berechnet und die endgültige Lösung für x, y dann durch Mittelung gebildet wird. Es müssen auch nicht notwendigerweise die Eckpunkte (beim EPI-Verfahren) oder die Endpunkte von k-Raumpfaden (beim Radial-Verfahren) herangezogen werden - es können auch die Phasenwerte in anderen Abtastpunkten ausgewertet werden. Die gezeigten Lösungen stellen jedoch eine besonders schnelle und einfache Lösung dar. Anstelle der Phasenwerte $\Phi(t_i)$ können auch die Abtastwerte $S(t_i)$ an den gezeigten Abtastpunkten ausgewertet und daraus die Mikrospulenposition bestimmt werden.

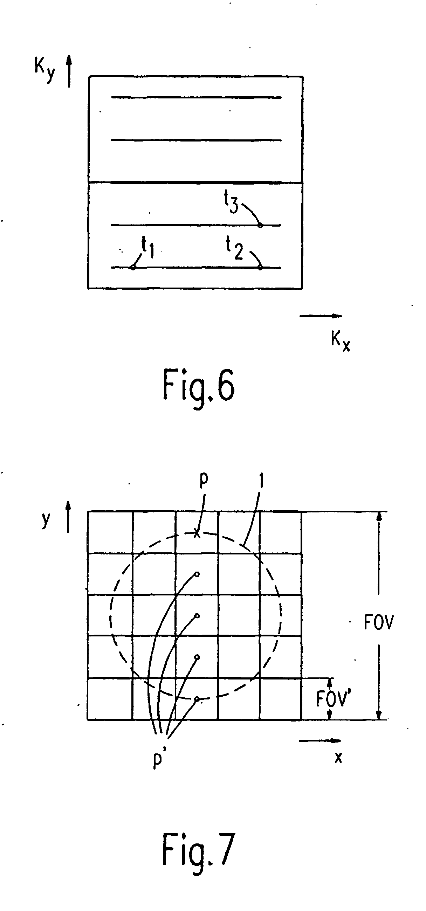

Eine weitere Ausgestaltung des erfindungsgemäßen MR-Verfahrens, bei der der k-Raum nicht kontinuierlich abgetastet wird, ist in Fig. 6 gezeigt. Die Abtastung des k-Raumes beim dort gezeigten Spin-Warp-Verfahren entlang parallel zur $k_x$-Achse verlaufender Linien. Nach einer Hochfrequenzanregung werden eine oder mehrere Linien im k-Raum ausgelesen (durchgezogene Linien in Fig. 6). Werden mehrere Linien im k-Raum gemessen und wird dabei der k-Raum gleichmäßig überstrichen, resultiert daraus eine Unterabtastung des k-Raumes senkrecht zur Ausleserichtung. Das entspricht der Abtastung des physikalischen Ortsraumes in der y-Richtung mit reduziertem Sichtbereich (field of view, FOV). Aus Phasenwerten $\Phi(t_i)$ bzw. Signalwerten $S(t_i)$, die an Meßpunkten $t_i$, z.B. $t_1$ und $t_2$ auf einer k-Raumlinie gemessen wurden, kann analog zu Gleichung (14) die x-Position exakt bestimmt werden. Die y-Position der Mikrospule kann dagegen nur unter Zuhilfenahme der Information von Meßpunkt $t_3$, der auf einer anderen, vorzugsweise benachbarten Linie liegt, bestimmt werden zu

$$y = y_0 + n * \text{FOV/L} \, , \qquad\qquad (18)$$

wobei n eine ganze Zahl, FOV die Größe des Sichtfeldes und die ganze Zahl L der Abstand, angegeben in Einheiten des Phasenkodierinkrementes, benachbarter paralleler k-Raumlinien ist. Der Wert FOV' = FOV/ L wird als reduziertes Sichtfeld bezeichnet. In Fig. 7 ist dies nochmals verdeutlicht. Im Ortsraum ist dort die Lage der Mikrospule eingezeichnet, die sich aus Gleichung (18) für n=0 ergibt (mit p bezeichnet). Für andere Werte von n ergeben sich andere Positionen (andere y-Werte) der Mikrospule, die mit p' bezeichnet sind. Die wahre Position der Mikrospule ist bis auf n $\in$ (0, ..., L-1) unbestimmt. Häufig kann jedoch aus anderen Nebenbedingungen der Wert für n und damit die tatsächliche Lage der Mikrospule bestimmt werden. Dies ist der Fall, wenn beispielsweise über die Fortbewegungsgeschwindigkeit der Mikrospule bekannt ist, daß sich die Mikrospule innerhalb zweier aufeinanderfolgender Positionsbestimmungen nicht weiter als FOV' bewegen kann. Auch Kenntnisse über die Fortbewegungsrichtung der Mikrospule oder deren anfängliche Lage können dabei herangezogen werden. Eine genaue Bestimmung der Position der Mikrospule ist auch dann möglich, wenn der k-Raum nach diesem Abtastverfahren vollständig abgetastet ist und währenddessen keine Bewegung der Mikrospule stattgefunden hat.

Das beschriebene Verfahren läßt sich auch auf die dreidimensionale Positionsbestimmung erweitern. Dazu muß das Mikrospulen-MR-Signal zusätzlich während des Anliegens eines z-Magnetfeldgradienten gemessen und analog zum oben beschriebenen Verfahren die z-Koordinate der Mikrospule bestimmt werden. Zur Bestimmung der Position der Mikrospule sind im allgemeinen mindestens vier Abtastpunkte erforderlich.

Das erfindungsgemäße MR-Verfahren und die MR-Anordnung können auch zur Positionsbestimmung einer Mikrospule angewendet werden, ohne daß gleichzeitig MR-Signale zur Erstellung von MR-Bildern erfaßt werden. Beispielsweise kann die mit dem erfindungsgemäßen Verfahren bestimmte Mikrospulenposition in ein vorher erstelltes (ggf. dreidimensionales) MR-Bild oder ein mit einer anderen Meßanordnung erstelltes Bild (z.B. ein Ultraschall- oder ein Computertomographiebild) eingeblendet werden.

Die Positionsbestimmung kann auch in einem anderen als dem beschriebenen Koordinatensystem durchgeführt werden, beispielsweise in einem vom Benutzer abhängig von der Lage der Abtastschichten liegenden Koordinatensystem.

**Patentansprüche**

1. Verfahren der magnetischen Resonanz (MR) zur Bestimmung der Position wenigstens einer Mikrospule (11, 12), die sich in oder an einem in einem Untersuchungsbereich befindlichen Untersuchungsobjekt (1) befindet, wobei während der Erfassung von MR-Signalen mittels der Mikrospule mindestens ein veränderbares magnetisches Gradientenfeld auf den Untersuchungsbereich einwirkt, so daß der k-Raum mindestens zweidimensional an Abtastpunkten ($k_x(t_i)$, $k_y(t_i)$) abgetastet wird,

**dadurch gekennzeichnet, daß** die zweidimensionale Position (x, y) der Mikrospule (11, 12) direkt, das heißt ohne vorherige Fourier - oder andere Transformation, aus wenigstens zwei Abtastwerten ($S(t_i)$) eines Mikrospulen-MR-Signals und den k-Raum-Koordinaten der zugeordneten Abtastpunkte ($k_x(t_i)$, $ky(t_i)$) bestimmt wird.

2. MR-Verfahren nach Anspruch 1,
   **dadurch gekennzeichnet, daß** die Phasenwerte ($\Phi(t_i)$) von Abtastwerten ($S(t_i)$) eines Mikrospulen-MR-Signals ermittelt werden und daß die Position der Mikrospule (11, 12) aus wenigstens zwei Phasenwerten ($\Phi(t_i)$) und den k-Raum-Koordinaten der zugeordneten Abtastpunkte ($k_x(t_i)$, $k_y(t_i)$) bestimmt wird.

3. MR-Verfahren nach einem der vorhergehenden Ansprüche,
   **dadurch gekennzeichnet, daß** die Position der Mikrospule (11, 12) durch Minimierung einer Fehlerfunktion (F, F') bestimmt wird, wobei die Fehlerfunktion (F, F') aus Gleichungen gebildet wird, welche jeweils den Zusammenhang zwischen einem Abtastwert ($S(t_i)$) eines Mikrospulen-MR-Signals, den k-Raum-Koordinaten der zugeordneten Abtastpunkte ($k_x(t_i)$, $k_y(t_i)$) und den gesuchten Positionswerten (x, y) der Mikrospule (11, 12) beschreiben.

4. MR-Verfahren nach Anspruch 3,
   **dadurch gekennzeichnet, daß** die Fehlerfunktion (F) aus Differenzwerten ($D(t_i)$) zwischen jeweils einem Abtastwert ($S(t_i)$) eines Mikrospulen-MR-Signals und einem aus den k-Raum-Koordinaten der zugeordneten Abtastpunkte ($k_x(t_i)$, $k_y(t_i)$) und den Positionswerten (x, y) der Mikrospule (11, 12) gebildeten Signal-Rechenwert ($R(t_i)$) gebildet wird und daß zur Minimierung der Fehlerfunktion Werte der Fehlerfunktion (F) für verschiedene Positionswerte (x, y) ermittelt werden.

5. MR-Verfahren nach Anspruch 3,
   **dadurch gekennzeichnet, daß** die Phasenwerte ($\Phi(t_i)$) von Abtastwerten ($S(t_i)$) eines Mikrospulen-MR-Signals ermittelt werden, daß die Fehlerfunktion (F') aus Differenzwerten ($D'(t_i)$) zwischen jeweils einem Phasenwert ($\Phi(t_i)$) und einem aus den k-Raum-Koordinaten der zugeordneten Abtastpunkte ($k_x(t_i)$, $k_y(t_i)$) und den Positionswerten (x, y) der Mikrospule (11, 12) gebildeten Phasen-Rechenwert ($R'(t_i)$) gebildet wird und daß zur Minimierung der Fehlerfunktion Werte der Fehlerfunktion (F') für verschiedene Positionswerte (x, y) ermittelt werden.

6. MR-Verfahren nach einem der vorhergehenden Ansprüche,
   **dadurch gekennzeichnet, daß** bei der Bestimmung der Position der Mikrospule (11, 12) Positionswerte (x', y') der vorherigen Position der Mikrospule (11, 12) und/oder die Bewegungsrichtung der Mikrospule berücksichtigt werden.

7. MR-Verfahren nach einem der vorhergehenden Ansprüche,
   **dadurch gekennzeichnet, daß** die Position der Mikrospule (11, 12) aus wenigstens zwei voneinander unabhängigen Gleichungen bestimmt wird, welche jeweils den Zusammenhang zwischen einem Abtastwert ($S(t_i)$) eines Mikrospulen-MR-Signals, den k-Raum-Koordinaten der zugeordneten Abtastpunkte ($k_x(t_i)$, $k_y(t_i)$) und den gesuchten Positionswerten (x, y) der Mikrospule (11, 12) beschreiben.

8. MR-Verfahren nach einem der vorhergehenden Ansprüche,
   **dadurch gekennzeichnet, daß** mittels einer Empfangsspulen-Anordnung (15) MR-Signale zur Bestimmung der Kernmagnetisierungsverteilung im Untersuchungsbereich und gleichzeitig dazu die Mikrospulen-MR-Signale (S) mittels einer Mikrospule (11, 12) detektiert werden.

9. MR-Anordnung mit einer Empfangsspulen-Anordnung (15) zum Empfangen von MR-Signalen, wenigstens einer Mikrospule (11, 12), Mitteln zum Empfangen von mittels der Mikrospule aufgenommenen MR-Signalen und mit Mitteln (3, 4, 5) zum Erzeugen mindestens eines, während der Erfassung von MR-Signalen mittels der Mikrospule auf den Untersuchungsbereich einwirkenden, veränderbaren magnetischen Gradientenfeldes zur mindestens zweidimensionalen Abtastung des k-Raumes an Abtastpunkten ($k_x(t_i)$, $k_y(t_i)$),
   **dadurch gekennzeichnet, daß** Mittel (14) vorgesehen sind zur Bestimmung der zweidimensionalen Position (x, y) der Mikrospule (11, 12) direkt, das heißt ohne vorherige Fourier - oder andere Transformation, aus wenigstens zwei Abtastwerten ($S(t_i)$) eines Mikrospulen-MR-Signals und den k-Raum-Koordinaten der zugeordneten Abtastpunkte ($k_x(t_i)$, $k_y(t_i)$).

**Claims**

1. A magnetic resonance (MR) method for determining the position of at least one microcoil (11, 12) which is provided in or on an object (1) to be examined which is situated in an examination zone, at least one variable magnetic gradient field acting on the examination zone during the acquisition of MR signals by means of the microcoil, so that the k space is scanned at least two-dimensionally at scanning points $(k_x(t_i), k_y(t_i))$, **characterized in that** the two-dimensional position (x, y) of the microcoil (11, 12) is determined directly, i.e. without a previous Fourier or other transformation, from at least two scanning values $(S(t_i))$ of a microcoil MR signal and the k space coordinates of the associated scanning points $(k_x(t_i), k_y(t_i))$.

2. An MR method as claimed in Claim 1, **characterized in that** the phase values $(\Phi(t_i))$ of scanning values $(S(t_i))$ of a microcoil MR signal are determined and that the position of the microcoil (11, 12) is determined from at least two phase values $(\Phi(t_i))$ and the k space coordinates of the associated scanning points $(k_x(t_i), k_y(t_i))$.

3. An MR method as claimed in one of the preceding Claims, **characterized in that** the position of the microcoil (11, 12) is determined by minimizing an error function (F, F'), the error function (F, F') being formed from equations describing the respective relationship between a scanning value $(S(t_i))$ of a microcoil MR signal, the k space coordinates of the associated scanning points $(k_x(t_i), k_y(t_i))$ and the position values (x, y) searched for the microcoil (11, 12).

4. An MR method as claimed in Claim 3, **characterized in that** the error function (F) is formed from difference values $(D(t_i))$ between a respective scanning value $(S(t_i))$ of a microcoil MR signal and a signal characteristic value $(R(t_i))$ formed from the k space coordinates of the associated scanning points $(k_x(t_i), k_y(t_i))$ and the position values (x, y) of the microcoil (11, 12), and that the error function (F) is determined for different position values (x, y) in order to minimize the error function.

5. An MR method as claimed in Claim 3, **characterized in that** the phase values $(\Phi(t_i))$ of scanning values $(S(t_i))$ of a microcoil MR signal are determined, that the error function (F') is formed from difference values $(D'(t_i))$ between a respective phase value $(\Phi(t_i))$ and a phase characteristic value $(R'(t_i))$ formed from the k space coordinates of the associated scanning points $(k_x(t_i), k_y(t_i))$ and the position values (x, y) of the microcoil (11, 12), and that values of the error function (F') are determined for different position values (x, y) in order to minimize the error function.

6. An MR method as claimed in one of the preceding Claims, **characterized in that** position values (x', y') of the previous position of the microcoil (11, 12) and/or the direction of movement of the microcoil are taken into account in order to determine the position of the microcoil (11, 12).

7. An MR method as claimed in one of the preceding Claims, **characterized in that** the position of the microcoil (11, 12) is determined from at least two mutually independent equations which describe the respective relationship between a scanning value $(S(t_i))$ of a microcoil MR signal, the k space coordinates of the associated scanning points $(k_x(t_i), k_y(t_i))$ and the position values (x, y) searched for the microcoil (11, 12).

8. An MR method as claimed in one of the preceding Claims, **characterized in that** a receiving coil system (15) detects MR signals in order to determine the nuclear magnetization distribution in the examination zone and that at the same time the microcoil MR signals (S) are detected by means of a microcoil (11, 12).

9. An MR device which includes a receiving coil system (15) for receiving MR signals, at least one microcoil (11, 12), means for receiving MR signals picked up by means of the microcoil and means (3, 4, 5) for generating at least one variable magnetic gradient field which acts on the examination zone during the acquisition of MR signals by means of the microcoil in order to scan the k space at least two-dimensionally at scanning points $(k_x(t_i), k_y(t_i))$, **characterized in that** there are provided means (14) for determining the two-dimensional position (x, y) of the microcoil (11, 12) directly, i.e. without a previous Fourier or other transformation, from at least two scanning values $(S(t_i))$ of a microcoil MR signal and the k space coordinates of the associated scanning points $(k_x(t_i), k_y(t_i))$.

**Revendications**

1. Procédé de résonance magnétique (RM) pour la détermination de la position d'au moins une microbobine (11, 12) qui se trouve dans ou sur un objet d'examen (1) se trouvant dans une zone d'examen, dans lequel, pendant la saisie de signaux RM à l'aide de la microbobine, au moins un champ à gradient magnétique variable agit sur la zone d'examen, de telle sorte que l'espace k soit balayé au moins bidimensionnellement sur les points de balayage $(k_x(t_i), k_y(t_i))$,
   **caractérisé en ce que** la position bidimensionnelle (x, y) de la microbobine (11, 12) est déterminée directement, c'est-à-dire sans transformation de Fourier ou autre préalable, à partir d'au moins deux valeurs de balayage $(S(t_i))$ d'un signal RM de microbobines et des coordonnées de l'espace k des points de balayage attribués $(k_x(t_i), k_y(t_i))$.

2. Procédé RM selon la revendication 1,
   **caractérisé en ce que** les valeurs de phase $(\Phi(t_i))$ sont déterminées par les valeurs de balayage $(S(t_i))$ d'un signal RM de microbobines et que la position de la microbobine (11, 12) est déterminée à partir d'au moins deux valeurs de phase $(\Phi(t_i))$ et des coordonnées de l'espace k des points de balayage attribués $(k_x(t_i), k_y(t_i))$.

3. Procédé RM selon l'une des revendications précédentes,
   **caractérisé en ce que** la position de la microbobine (11, 12) est déterminée par minimisation d'une fonction d'erreur (F, F'), dans lequel la fonction d'erreur (F, F') est formée à partir d'équations qui décrivent respectivement le rapport entre une valeur de balayage $(S(t_i))$ d'un signal RM de microbobines, les coordonnées de l'espace k des points de balayage attribués $(k_x(t_i), k_y(t_i))$ et les valeurs de position recherchées (x, y) de la microbobine (11, 12).

4. Procédé RM selon la revendication 3,
   **caractérisé en ce que** la fonction d'erreur (F) est formée à partir des valeurs de différence $(D(t_i))$ entre, respectivement, une valeur de balayage $(S(t_i))$ d'un signal RM de microbobines et une valeur de calcul de signal $(R(t_i))$ formée à partir des coordonnées de l'espace k des points de balayage attribués $(k_x(t_i), k_y(t_i))$ et des valeurs de position (x, y) de la microbobine (11, 12) et que des valeurs de la fonction d'erreur (F) sont déterminées pour les différentes valeurs de position (x, y) en vue de minimiser la fonction d'erreur.

5. Procédé RM selon la revendication 3,
   **caractérisé en ce que** les valeurs de phase $(\Phi(t_i))$ sont déterminées par les valeurs de balayage $(S(t_i))$ d'un signal RM de microbobines, que la fonction d'erreur (F') est formée à partir des valeurs de différence $(D'(t_i))$ entre, respectivement, une valeur de phase $(\Phi(t_i))$ et une valeur de calcul de phase $(R'(t_i))$ formée à partir des coordonnées de l'espace k des points de balayage attribués $(k_x(t_i), k_y(t_i))$ et les valeurs de position (x, y) de la microbobine (11, 12) et que des valeurs de la fonction d'erreur (F') sont déterminées pour différentes valeurs de position (x, y) afin de minimiser la fonction d'erreur.

6. Procédé RM selon l'une des revendications précédentes,
   **caractérisé en ce que** les valeurs de position (x', y') de la position précédente de la microbobine (11, 12) et/ou le sens de déplacement de la microbobine sont pris en considération pour la détermination de la position de la microbobine (11, 12).

7. Procédé RM selon l'une des revendications précédentes,
   **caractérisé en ce que** la position de la microbobine (11, 12) est déterminée à partir d'au moins deux équations indépendantes l'une de l'autre qui décrivent respectivement le rapport entre une valeur de balayage $(S(t_i))$ d'un signal RM de microbobines, les coordonnées de l'espace k des points de balayage attribués $(k_x(t_i), k_y(t_i))$ et les valeurs de position recherchées (x, y) de la microbobine (11, 12).

8. Procédé RM selon l'une des revendications précédentes,
   **caractérisé en ce que** des signaux RM sont détectés à l'aide d'un dispositif à bobines de réception (15) en vue de la détermination de la distribution de la magnétisation nucléaire dans la zone d'examen et, simultanément, des signaux RM de microbobines (S) à l'aide d'une microbobine (11, 12).

9. Dispositif RM avec un dispositif à bobines de réception (15) pour la réception de signaux RM, au moins une microbobine (11, 12), des moyens pour la réception des signaux RM enregistrés à l'aide de la microbobine et des moyens (3, 4, 5) pour la production d'au moins un champ à gradient magnétique variable agissant sur la zone d'examen pendant la saisie des signaux RM à l'aide de la microbobine en vue du balayage au moins bidimensionnel de l'espace k sur les points de balayage ($k_x(t_i)$, $k_y(t_i)$),

**caractérisé en ce qu'**il est prévu des moyens (14) pour la détermination de la position bidimensionnelle (x, y) de la microbobine (11, 12), directement, c'est-à-dire sans transformation de Fourier ou autre préalable, à partir d'au moins deux valeurs de balayage ($S(t_i)$) d'un signal RM de microbobines et des coordonnées de l'espace k des points de balayage attribués ($k_x(t_i)$, $k_y(t_i)$).

Fig.1

Fig.2

Fig.3

Fig.4

Fig.5

Fig.6

Fig.7